# FASCICULE DE BREVET EUROPEEN

(11) **EP 3 056 944 B1**
(45) Date de publication et mention de la délivrance du brevet: **26.04.2017**
(21) Numéro de dépôt: 15155280.9
(22) Date de dépôt: 16.02.2015
(51) Int. Cl.: G03F 7/16, B05C 5/02

(54) **Méthode et appareil de dispense d'une couche de photorésist sur un substrat**
Methode und Gerät zur Abgabe einer Fotoresistschicht auf ein Substrat
Method and apparatus for dispensing a photoresist layer on a substrate

(43) Date de publication de la demande: 17.08.2016
(73) Titulaire: Mimotec S.A., 1950 Sion (CH)
(72) Inventeur: Genolet, Grégoire, 1926 Fully (CH); Lorenz, Hubert, 1965 Savièse (CH); Pitteloud, Jean-Camil, 1981 Vex (CH)
(74) Mandataire: Leman Consulting S.A.

(56) Documents cités:
- US-A- 5 437 727
- US-A1- 2005 056 215

## Description

### Domaine de l'invention

La présente invention concerne le domaine de la fabrication de pièces mécaniques de petites dimensions obtenues par procédé UV-LIGA. En particulier, l'invention décrit une méthode et un appareil permettant d'appliquer sur un substrat une couche de photorésist homogène d'épaisseur uniforme.

### Arrière plan technique

Le procédé de fabrication de microcomposants mécaniques utilisant la technologie UV-LIGA (Lithographie Galvanoformung Abformung) est bien connu. En général, plusieurs pièces complexes, de grande précision et de résistance mécanique élevée peuvent être réalisées sur un même substrat, appelé wafer, comme par exemple des pièces pour l'horlogerie telles que par exemple des roues dentées, des cames, bascules, ponts, etc.

L'avantage de cette technologie est la possibilité de réaliser des composants d'une très grande précision en X et Y et avec une épaisseur allant jusqu'à plusieurs millimètres. Le procédé peut également s'appliquer en plusieurs étapes pour obtenir un composant à plusieurs niveaux, chaque niveau étant construit sur le précédent.

Une étape importante de ce procédé est l'application, sur une face d'un substrat conducteur, d'une couche de résine photosensible, appelée généralement photorésist, destinée à la fabrication d'un moule pour microcomposants mécaniques. Dans un procédé de photolithographie avec un photorésist négatif, la couche de photorésist est irradiée à travers un photomasque par un rayonnement UV qui polymérise les zones non masquées de la couche de photorésist. Les zones masquées sont éliminées chimiquement par un solvant, ce qui permet de définir sur le substrat des cavités d'un moule en photorésist. Une couche métallique est ensuite déposée par électroformage dans les cavités de ce moule afin d'obtenir des microcomposants mécaniques.

Afin d'obtenir une précision uniforme des pièces réalisées sur le substrat, une des exigences est de garantir une épaisseur constante de la couche de photorésist sur toute la surface du substrat. En effet, cette couche est généralement étalée par rotation sur un substrat généralement circulaire posé sur un support horizontal. Les forces d'inertie dues à la rotation du support et la viscosité du photorésist peuvent engendrer la formation d'un bourrelet le long du bord du substrat. Comme l'épaisseur de la couche de photorésist est plus grande le long du bord du substrat que sur le reste de sa surface, le photomasque ne peut pas y être appliqué de manière rigoureusement plane et avec un bon contact.

L'étalement du photorésist selon l'art antérieur est réalisé soit par un procédé appelé « spin-coating » ou par un procédé appelé « blade coating ».

L'avantage du procédé « spin coating » est qu'il permet d'étaler de façon très précise des couches fines de photorésist qui est dispensé sur le centre du substrat puis étalé par rotation du substrat autour d'un axe central. La force centrifuge due à la rotation appliquée sur le photorésist étale celui-ci vers les bords du substrat. Ce procédé est particulièrement bien adapté pour déposer un photorésist de basse viscosité en couches de faible épaisseur (inférieures à 10 microns). L'épaisseur de photorésist est donnée essentiellement par la vitesse de rotation du substrat et par sa viscosité. En fonction de ces deux paramètres une couche limite qui définit l'épaisseur finale du photorésist est atteinte. Pour obtenir des couches plus épaisses, il faut augmenter la viscosité du photorésist et/ou diminuer la vitesse et/ou la durée de rotation du substrat. L'épaisseur du photorésist n'est alors plus donnée par la couche limite, mais par la quantité de photorésist restant sur le substrat après un temps de rotation prédéfini.

L'inconvénient principal de ce procédé « spin coating » est la formation d'un bourrelet sur l'extérieur du substrat appelé « edge bead ». Ce bourrelet conduit à une inhomogénéité d'épaisseur radiale du photorésist sur le substrat. De plus, ce procédé n'est pas adapté pour des épaisseurs de photorésist supérieures à 300 microns. Pour de telles épaisseurs, il faut augmenter la viscosité du photorésist ou diminuer la vitesse de rotation du substrat dans des limites non utilisables. De plus, l'épaisseur dépend fortement de la viscosité du photorésist et de variations de la température lors de la dispense ce qui engendre de fortes variations d'épaisseur empêchant le contrôle précis de celle-ci.

Le procédé « blade coating » consiste à étaler le photorésist déposé sur le substrat avec une lame se déplaçant au-dessus du substrat de manière à égaliser la surface de photorésist jusqu'à une épaisseur prédéterminée. Bien que ce procédé permette de résoudre le problème de la formation du bourrelet au bord du substrat en utilisant un support de substrat non rotatif, il est fortement tributaire de la viscosité du photorésist et la grande précision de l'épaisseur attendue ne peut pas être atteinte. De plus ce procédé est peu adapté en cas d'utilisation de substrats non rectangulaires.

D'autres procédés connus sous l'appellation « spinless coating » permettent de déposer du photorésist sur des substrats non rotatifs ou fixes. Des exemples de « spinless coating » sont traités dans les documents suivants :
US2005/089790A1 qui décrit essentiellement une composition particulière de photorésist adaptée à un dispositif de dispense non rotatif. Un exemple de dispositif de dispense « spinless coater » comprend une buse munie d'une fente se déplaçant selon une direction au dessus d'un substrat fixe pour déposer le photorésist. L'avantage de ce procédé est d'éviter l'enlèvement du bourrelet se formant lorsque le substrat est en rotation. Ce dispositif présente l'inconvénient de ne pas pouvoir être utilisé pour des substrats circulaires.

US6117481 qui décrit un appareil de dispense de photorésist dont la buse en forme de fente se déplace linéairement au dessus du substrat selon une direction à la façon d'un scanner. Le photorésist est alors déposé par gouttes successives sortant de la buse. Selon une option, le substrat est placé sur un support oscillant pour uniformiser la couche de photorésist après déposition.

De plus, lors d'un étalement de photorésist sur une surface pré-structurée, comme par exemple dans le cas de la fabrication d'un moule multi-niveaux où une couche de photorésist additionnelle est déposée sur une couche de photorésist comportant des cavités photo fabriquées précédemment, des bulles d'air sont généralement piégées dans ces cavités. Ces bulles perturbent la photolithographie et empêchent une définition précise du moule. En effet, le photorésist ne remplissant pas entièrement les cavités inférieures du moule, la précision et la forme finale de celles-ci sont affectées rendant le moule multi-niveaux inutilisable pour la galvanoplastie.

Les méthodes conventionnelles d'étalement de photorésist comme le « spin coating » utilisant des supports rotatifs nécessitent en général des substrats circulaires avec des diamètres précis. Or, en technologie UV-LIGA, les substrats utilisés pour la fabrication de moules peuvent être de forme carrée, rectangulaire ou de formes quelconque avec des dimensions variables et de ce fait il devient nécessaire de disposer d'un appareil de dispense de photorésist adapté à ces formes et dimensions. Les photomasques peuvent également être de forme carrée ou rectangulaire nécessitant un substrat de forme analogue pour maximiser la surface disponible pour la photolithographie.

### Description sommaire de l'invention

Le but de la présente invention est de pallier les inconvénients des méthodes et appareils de dispense de photorésist de l'art antérieur en proposant une méthode et un appareil permettant d'étaler des couches épaisses de photorésist allant de 50 microns à quelques millimètres sur un substrat de forme et d'épaisseur quelconque posé sur un support non rotatif.

Ces buts sont atteints par une méthode de dispense d'une couche de photorésist sur un substrat substantiellement plan placé sur un support horizontal, le photorésist étant déposé sur le substrat par un appareil comprenant un dispositif de dispense de photorésist, placé au-dessus du substrat, relié à un réservoir de photorésist, la méthode est caractérisée en ce qu'elle comprend les étape suivantes :
- créer un vide partiel à l'intérieur d'une enceinte englobant au moins le dispositif de dispense de photorésist, le support et le substrat,
- activer un dispositif d'entraînement engendrant, sur le support du substrat, des mouvements de translation selon un premier axe et sur le dispositif de dispense de photorésist des mouvements de translation selon un second axe perpendiculaire au premier axe, le premier axe et le second axe étant parallèles au plan du substrat ou engendrant sur le support du substrat et/ou sur le dispositif de dispense de photorésist des mouvements de translation selon le premier axe et le second axe, et
- déposer au moyen du dispositif de dispense une couche de photorésist sur le substrat, le photorésist s'écoulant par au moins un orifice dudit dispositif de dispense selon une trajectoire prédéterminée sur le substrat s'étale en une couche homogène d'épaisseur uniforme sur ledit substrat.

La présente invention se rapporte également à un appareil de dispense d'une couche de photorésist sur un substrat substantiellement plan placé sur un support horizontal, ledit appareil comprenant au moins un dispositif de dispense de photorésist, placé au-dessus du substrat, relié à un réservoir de photorésist, ledit dispositif de dispense comportant un orifice apte à déposer une couche de photorésist sur le substrat, l'appareil de dispense est caractérisé en ce qu'il comprend :
- une enceinte, englobant au moins le dispositif de dispense de photorésist, le support et le substrat, couplée à une pompe à vide destinée à créer un vide partiel à l'intérieur de ladite enceinte,
- un dispositif d'entraînement configuré de manière à engendrer, sur le support du substrat, des mouvements de translation selon un premier axe et sur le dispositif de dispense de photorésist des mouvements de translation selon un second axe perpendiculaire au premier axe, le premier axe et le second axe étant parallèles au plan du substrat ou de manière à engendrer sur le support du substrat et/ou sur le dispositif de dispense de photorésist des mouvements de translation selon le premier axe et le second axe, de sorte que le photorésist forme une trajectoire prédéterminée sur le substrat et s'étale en une couche homogène d'épaisseur uniforme sur ledit substrat.

Selon une variante préférée, le dispositif de dispense est fixe et le support du substrat se déplace en effectuant des mouvements de translation horizontaux selon le premier et le second axe correspondant aux axes X et Y du plan du support. Ces mouvements effectués lors du dépôt du photorésist permettent à celui-ci de former sur le substrat une trajectoire dépendant notamment de la forme géométrique du substrat. Le support peut également se déplacer selon un troisième axe correspondant à l'axe Z perpendiculaire au plan du support afin d'ajuster la distance entre l'orifice du dispositif de dispense et la surface du substrat en fonction notamment de la viscosité du photorésist et de l'épaisseur des différentes couches de photorésist superposées.

Selon une autre variante préférée, le support sur lequel est posé le substrat est fixe et le dispositif de dispense se déplace selon le premier et le second axe correspondant aux axes X et Y dans un plan parallèle à celui du substrat. Dans cette variante, le dispositif de dispense peut également se déplacer selon un troisième axe correspondant à l'axe Z perpendiculaire au plan du support pour ajuster sa hauteur par rapport au substrat.

Selon une autre variante, le support sur lequel est posé le substrat se déplace selon l'axe X et le dispositif de dispense se déplace selon l'axe Y perpendiculaire à l'axe X, les deux axes X et Y étant parallèles au plan du substrat. Selon une autre configuration, le support se déplace selon l'axe Y tandis que le dispositif de dispense se déplace selon l'axe X. Dans ces deux configurations, le dispositif de dispense peut également se déplacer selon l'axe Z perpendiculaire au plan du support, comme dans les variantes précédentes.

Selon une autre variante, le dispositif de dispense et le support du substrat se déplacent chacun selon les axes X et Y en effectuant des mouvements de translation horizontaux. Dans ce cas également, le dispositif de dispense peut se déplacer selon l'axe Z.

Dans chacune de ces variantes, l'étalement du photorésist sur le substrat est ainsi assuré par une combinaison des mouvements du support du substrat et/ou du dispositif de dispense résultant en une trajectoire donnée et par des forces dues à la viscosité du photorésist et à la tension superficielle du substrat. L'étalement du photorésist peut être accéléré en diminuant sa viscosité par une élévation de la température, par exemple, au moyen d'un chauffage intégré soit au support du substrat, soit au dispositif de dispense du photorésist ou soit au réservoir contenant le photorésist.

La trajectoire du photorésist s'écoulant sur le substrat engendrée par les mouvements de translation du support du substrat et/ou du dispositif de dispense permet d'optimiser la dispense de photorésist afin de garantir une épaisseur finale uniforme sur toute la surface du substrat quelle que soient la forme de son contour et sa dimension (circulaire, carré, rectangulaire, triangulaire, polygonale etc.)

Le vide partiel créé préalablement, c'est-à-dire avant le dépôt du photorésist, par une pompe à vide couplée à l'enceinte englobant le dispositif de dispense de photorésist et le support sur lequel est placé le substrat permet d'éliminer les bulles d'air pouvant se former dans les cavités lors de la réalisation d'un moule multi-niveaux ou lors de la dispense sur un substrat non planaire dans lequel des cavités ont été gravées ou usinées. La couche de photorésist devient ainsi homogène sur toute son épaisseur qui est constante sur toute la surface utile du substrat.

Un avantage important de l'appareil et de la méthode selon l'invention est son large spectre d'applications. Il permet le dépôt de tous types de photorésist positif ou négatif destiné à la photolithographie, de viscosité diverse en couches d'épaisseurs allant de 50 microns à quelques millimètres sur un substrat substantiellement plan de forme et d'épaisseur variable.

### Brève description des figures

L'invention sera mieux comprise grâce à la description détaillée qui va suivre et qui se réfère aux figures annexées données à titre d'exemples nullement limitatifs.
La figure 1 illustre une première variante de l'appareil selon l'invention dans lequel le support du substrat se déplace dans un plan parallèle au substrat selon des axes X, Y et Z, le dispositif de dispense étant fixe.
La figure 2 illustre une seconde variante de l'appareil selon l'invention dans lequel le dispositif de dispense se déplace dans un plan parallèle au substrat selon des axes X, Y et Z, le support du substrat étant fixe.
La figure 3 illustre un exemple de trajectoire d'un dépôt de photorésist sur un substrat rectangulaire.
La figure 4 illustre une coupe selon l'axe A-A du substrat de la figure 3
La figure 5 illustre la coupe de la figure 4 avec une couche de photorésist d'épaisseur uniforme après étalement sous l'effet de forces engendrées par la viscosité du photorésist et les tensions superficielles du substrat.

### Description détaillée de l'invention

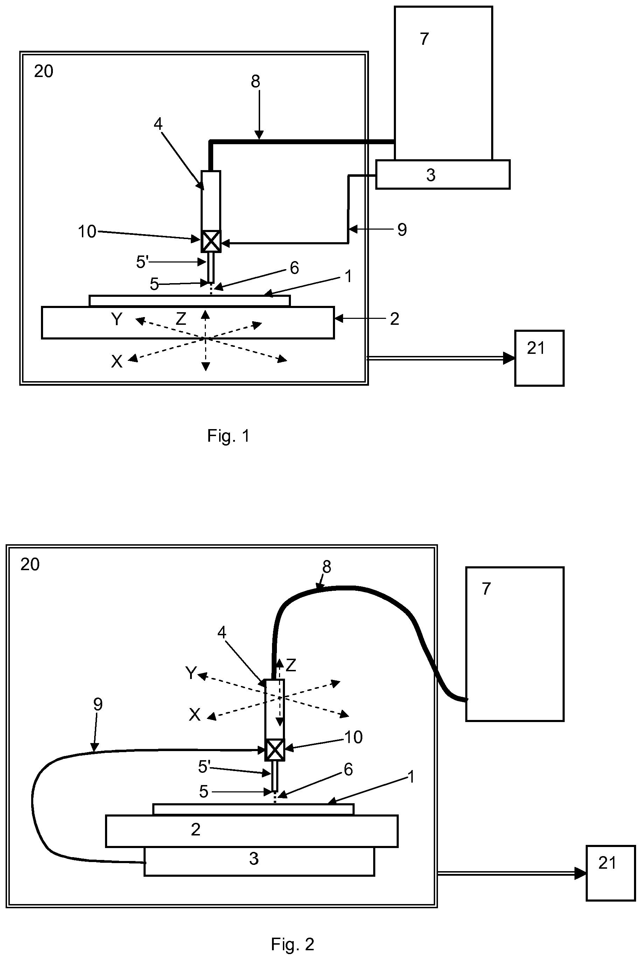

Une première variante préférée de l'appareil selon l'invention représentée schématiquement par la figure 1 comprend un support (2) horizontal mobile sur lequel est posé un substrat (1), un dispositif de dispense (4) de photorésist (6) fixe équipé d'un orifice (5) par lequel s'écoule le photorésist (6) en provenance d'un réservoir (7). Selon une réalisation, l'orifice (5) est situé à l'extrémité d'une buse (5') fixée au dispositif de dispense (4). Le photorésist (6) s'écoule hors de l'orifice (5) soit sous une pression prédéterminée, soit par gravité et ceci par le biais de la buse (5') ou directement sans passer par une buse (5').

Le substrat substantiellement plan peut comporter une surface lisse ou pré-structurée avec des cavités et des reliefs formés par un procédé DRIE (Deep reactive-ion etching) par exemple. Dans le cas d'une fabrication d'un moule en photorésist à plusieurs niveaux, la surface du substrat peut également comporter une ou plusieurs couches de photorésist préalablement développées comportant des cavités et des reliefs.

Le support (2) sur lequel est posé le substrat (1) se déplace, dans un plan horizontal parallèle au substrat, grâce à un dispositif d'entraînement non représenté en effectuant des mouvements de translation selon les axes X et/ou Y. Ces mouvements permettent au photorésist (6) s'écoulant par la buse (5') fixe de se déposer sur le substrat (1) en formant une trajectoire prédéterminée quelle que soit la forme et la dimension du substrat (1). Selon une réalisation préférée, le dispositif d'entraînement comporte des moteurs électriques couplés mécaniquement au support et commandés par un dispositif électronique de manière à effectuer une combinaison de translations du support selon les axes X et Y.

Le support (2) peut également se déplacer selon un axe vertical Z perpendiculaire au plan du substrat (1) grâce à un moteur commandé de manière à maintenir une distance prédéterminée entre la buse (5') et la surface supérieure du substrat (1) en fonction de caractéristiques d'écoulement du photorésist comme par exemple la viscosité ou le débit d'écoulement.

Selon une réalisation, un dispositif de pesage (3), consistant par exemple en une balance électronique de précision, mesure la masse du photorésist et contrôle sa dispense sur le substrat (1) à l'aide de moyens de contrôle (9, 10). Le dispositif de pesage (3), respectivement la balance, est associé au réservoir (7) séparé de l'enceinte (20) englobant au moins le dispositif de dispense de photorésist (4), le support (2) et le substrat (1). Dans cette configuration, la balance mesure la masse du photorésist (6) soustraite du réservoir (7) correspondant à celle déposée sur le substrat (1) par le dispositif de dispense (4). La buse (5') du dispositif de dispense (4) peut être connectée au réservoir (7) par un conduit (8) rigide car celle-ci reste dans une position fixe au dessus du substrat (1). Lorsqu'une masse de consigne préalablement mémorisée est atteinte, le dépôt de photorésist (6) s'arrête grâce à la rétroaction de la balance sur le dispositif de dispense (4) qui peut être équipé d'une électrovanne contrôlant le débit du photorésist.

La mesure de la quantité de photorésist déposée sur une surface donnée permet de déterminer son épaisseur. Afin de s'affranchir des variations de température et de viscosité, le dispositif de pesage mesure la masse du photorésist déposé.

L'appareil comporte également une enceinte (20) englobant au moins le support (2), le substrat (1) et le dispositif de dispense (4) à l'intérieur de laquelle un vide partiel est créé à l'aide d'une pompe à vide (21) avant le début du dépôt de photorésist sur le substrat. Par vide partiel, on entend un environnement où la pression est inférieure à la pression atmosphérique qui est en général de l'ordre de 100 kPa. Dans le cas d'un dépôt sur un substrat lisse, la pression à l'intérieur de l'enceinte est réglée à une valeur comprise entre 60 kPa et 80 kPa. Dans le cas d'un substrat comportant une surface pré-structurée avec des cavités et des reliefs, la pression est réglée à une valeur plus basse comprise entre 10 kPa et 30 kPa permettant d'éviter d'emprisonner des bulles d'air lors de la dépose du photorésist sur les cavités formées précédemment sur le substrat. De même, des bulles présentes dans le photorésist lors de sa dispense ou de son étalement sur le substrat peuvent également être éliminées afin de rendre la couche de photorésist parfaitement homogène.

Le substrat (1) substantiellement plan est en général positionné sur le support (2) au moyen d'ergots ou de goupilles. Lorsque la surface du substrat est pré-structurée, le substrat (1) a tendance à se bomber, dans ce cas il peut également être fixé par aspiration par vide d'air afin de l'aplanir pour autant que la différence entre la pression dans l'enceinte (20) et celle dans le support (2) résultant de l'aspiration soit suffisante.

Une seconde variante préférée de l'appareil illustrée par la figure 2 se distingue de la première variante de la figure 1 par le fait que le dispositif de dispense se déplace tandis que le support du substrat reste fixe.

Le dispositif de dispense (4), respectivement la buse (5') située au-dessus du substrat (1) se déplace en effectuant des mouvements de translation dans un plan X-Y horizontal parallèle à celui du substrat (1) de manière à déposer le photorésist (6) sur le substrat (1) en suivant une trajectoire prédéterminée. Selon une réalisation préférée, ces mouvements sont assurés par des moteurs électriques couplés mécaniquement à la buse (5') et commandés de manière à effectuer une combinaison de translations selon les axes X et Y.

Le photorésist (6) stocké dans le réservoir (7) détaché du dispositif de dispense (4) est acheminé à la buse (5') à travers un conduit (8) flexible permettant un déplacement sans entrave de celle-ci munie d'au moins un orifice (5). La buse (5') peut également se déplacer verticalement selon un axe Z perpendiculaire au plan du substrat afin d'ajuster sa hauteur par rapport au substrat par analogie au déplacement vertical du support de la première variante.

Comme le support (2) portant le substrat (1) est fixe, le dispositif de pesage (3) peut être associé au support (2) du substrat (1) de manière à mesurer directement la masse du photorésist (6) tout au long du processus de dispense sur le substrat (1). Lorsque la masse atteint une valeur de consigne prédéterminée, la balance transmet un signal électrique via une connexion (9) au dispositif de dispense (4) muni de moyens de contrôle (10) composés par exemple d'une électrovanne qui, en se fermant, arrête le dépôt du photorésist (6) sur le substrat (1).

Afin d'obtenir un pesage du photorésist déposé sur le substrat plus précis, la variante de l'appareil dans laquelle le support est fixe et la buse mobile sera préférée.

Selon une autre configuration, le dispositif de pesage (3) peut également être disposé sous le réservoir de photorésist (7) comme dans la variante précédente où le support (2) se déplace et la buse (5') reste fixe.

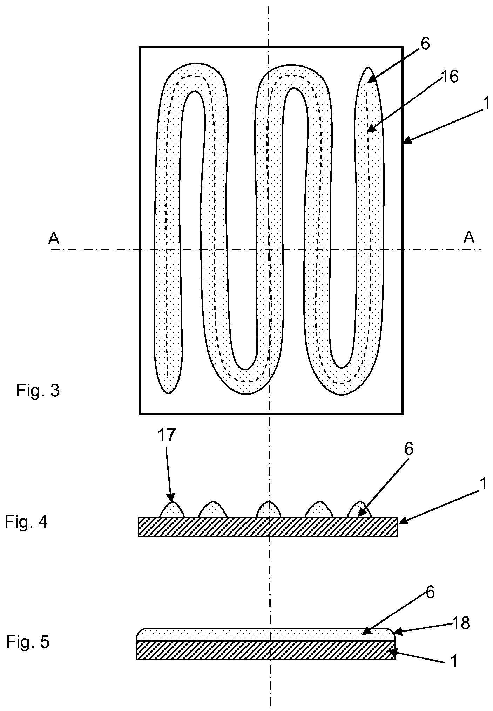

Selon une variante, le débit du photorésist (6), c'est-à-dire la quantité de photorésist (6) s'écoulant hors de l'orifice (5) de la buse (5') par unité de temps est contrôlée en fonction du chemin parcouru par la buse (5') ou de la position de celle-ci par rapport au substrat (1). Par exemple, sur une trajectoire continue en forme de zigzag comme illustré par la figure 4, le débit du photorésist peut être plus élevé lorsque la buse (5') débute son parcours à partir du bord du substrat (1) tandis que lorsqu'elle termine son parcours au centre du substrat (1) le débit devient plus faible avant l'arrêt lorsque la masse finale est atteinte.

Selon une autre variante, le débit est constant tout au long de la trajectoire. Selon la forme du substrat (1), la trajectoire peut également être segmentée ou discontinue ou parcourue avec une vitesse variable, c'est-à-dire que l'écoulement du photorésist est interrompu puis repris après un déplacement de la buse (5') sur une certaine distance sans écoulement de photorésist. Ainsi, quelle que soit la forme de la trajectoire continue ou non, le dépôt de photorésist (6) ne se termine définitivement que lorsque la masse correspondant à une quantité de photorésist prédéfinie est atteinte. L'épaisseur du photorésist (6) déposé se calcule en connaissant sa masse ou sa quantité, respectivement son poids spécifique ou sa densité et la surface du substrat, le photorésist (6) étant déposé en général sur la surface entière du substrat (1).

Il est à noter que le dispositif de dispense (4) peut comporter plusieurs buses (5') munies chacune d'un orifice (5) ou une buse (5') munies de plusieurs orifices (5) dans toutes les configurations de l'appareil dispensant soit du photorésist (6) provenant d'un même réservoir (7) ou de réservoirs solidaires d'une ou d'un ensemble de buses (5'). Selon les variantes le ou les réservoirs (7) peuvent être embarqués sur le dispositif de dispense (4) à l'intérieur de l'enceinte (20) ou séparés de l'enceinte (20) et reliés aux buses (5') par des conduits (8) appropriés. La balance est de préférence disposée sous le support (2) du substrat (1) particulièrement dans les configurations à réservoirs (7) multiples embarqués ou non et avec un support de substrat fixe afin de mesurer la masse totale du photorésist (6) déposée avec la plus grande précision possible.

La figure 3 montre un exemple de trajectoire (16) de dispense de photorésist (6) sur un substrat (1) rectangulaire résultant du déplacement X-Y du support (2) ou de la buse (5') du dispositif de dispense (4). La forme de la trajectoire, la largeur et la hauteur du tracé de celle-ci dépendent d'une part de la forme du substrat et d'autre part de la viscosité et de la quantité de photorésist à déposer correspondant à l'épaisseur finale prévue pour la couche. Bien entendu, cet exemple de trajectoire peut également être obtenu avec les autres variantes de l'appareil dans lesquelles, le support se déplace selon l'axe X et le dispositif de dispense selon l'axe Y ou inversement, et dans la variante où le support et le dispositif de dispense se déplacent chacun selon les axes X et Y.

La figure 4 représente une coupe selon l'axe A-A du substrat de la figure 3 dans laquelle le photorésist (6) forme un relief (17) temporaire sur le substrat au moment de la dispense. Les forces engendrées à la fois par la tension superficielle et la viscosité du photorésist (forces de cohésion) aplanissent ce relief (17) en étalant le photorésist de manière uniforme sur toute la surface du substrat (1). Autrement dit, le photorésist "mouille" la surface entière du substrat (1) grâce aux propriétés physiques du photorésist (6) comme la densité et la viscosité et à celles de la surface du substrat qui doit être propre et dépourvue de toute impureté. Afin d'améliorer l'étalement du photorésist, le substrat peut être chauffé et/ou subir des activations de surface par plasma pour le rendre encore plus hydrophile.

Lorsque le photorésist est déposé sur une couche de photorésist polymérisé comportant des cavités ou sur un substrat non planaire comportant des reliefs ou des cavités, le vide partiel dans l'enceinte (20) permet d'éviter d'emprisonner des bulles d'air lors de cette dépose et d'éliminer celles qui pourraient se former dans la couche de photorésist.

Une élévation de la température au niveau du substrat par un corps de chauffe intégré au support permet d'accélérer l'étalement de la couche de photorésist sur le substrat lors du dépôt. La viscosité du photorésist diminue lorsque la température augmente. Le photorésist peut également être dispensé à chaud sur le substrat grâce à un chauffage intégré soit au niveau du dispositif de dispense dans la buse et/ou le conduit, soit dans le réservoir embarqué sur le dispositif de dispense ou soit dans le réservoir séparé selon l'une ou l'autre des configurations du dispositif de dispense.

L'épaisseur de la couche de photorésist ainsi formée est égale sur toute la surface du substrat sauf au bord où une légère décroissance de l'épaisseur peut être observée; celle-ci est représentée par les bords arrondis (18) dans la figure 5. La tension superficielle d'interface entre le substrat et le photorésist et les forces de cohésion du photorésist l'empêchent de s'écouler par-dessus les bords du substrat.

Cette bordure de petite largeur où l'épaisseur du photorésist est plus faible n'est pas utilisée lors de la fabrication des microcomposants mécaniques car le photorésist y est systématiquement éliminé lors de la photogravure.

Lors d'étapes succédant à la dispense du photorésist, le substrat (1) est enlevé du support (2) et placé dans un équipement chargé de sécher et durcir le photorésist avant l'exécution des processus de masquage, d'exposition, de développement du photorésist et d'électroformage résumés dans la section "Arrière plan technique".

Avec cette méthode d'étalement, tout le photorésist est gardé sur le substrat, il n'y a pas d'éjection de matière comme dans les appareils à support rotatif « spin coater », ce qui garantit un meilleur contrôle de l'épaisseur en fonction de la masse de la matière déposée et permet une automatisation facilitée de l'appareil de dispense.

## Revendications

1. Méthode de dispense d'une couche de photorésist (6) sur un substrat (1) substantiellement plan placé sur un support (2) horizontal, le photorésist (6) étant déposé sur le substrat (1) par un appareil comprenant un dispositif de dispense de photorésist (4), placé au-dessus du substrat (1), relié à un réservoir de photorésist (7), la méthode est **caractérisée en ce qu'**elle comprend les étape suivantes :
- créer préalablement un vide partiel à l'intérieur d'une enceinte (20) englobant au moins le dispositif de dispense de photorésist (4), le support (2) et le substrat (1),
- activer un dispositif d'entraînement engendrant, sur le support (2) du substrat (1), des mouvements de translation selon un premier axe (X ou Y) et sur le dispositif de dispense de photorésist (4) des mouvements de translation selon un second axe (Y ou X) perpendiculaire au premier axe (X ou Y), le premier axe et le second axe (X, Y) étant parallèles au plan du substrat (1) ou engendrant sur le support (2) du substrat (1) et/ou sur le dispositif de dispense de photorésist (4) des mouvements de translation selon le premier axe et le second axe (X, Y), et
- déposer au moyen du dispositif de dispense (4) une couche de photorésist (6) sur le substrat, le photorésist (6) s'écoulant par au moins un orifice (5) dudit dispositif de dispense (4) selon une trajectoire prédéterminée sur le substrat (1) s'étale en une couche homogène d'épaisseur uniforme sur ledit substrat (1).

2. Méthode selon la revendication 1 **caractérisée en ce que** le dispositif d'entraînement engendre sur le support (2) du substrat des mouvements de translation selon le premier et le second axe (X, Y) dans un plan horizontal parallèle au plan du substrat (1) et selon un troisième axe (Z) perpendiculaire au plan du substrat (1), ledit mouvement vertical définissant une distance prédéterminée entre l'orifice (5) du dispositif de dispense de photorésist (4) et le substrat (1), le dispositif de dispense de photorésist (4) étant dans une position fixe au dessus du substrat (1).

3. Méthode selon la revendication 1 **caractérisée en ce que** le dispositif d'entraînement engendre sur le dispositif de dispense de photorésist (4) des mouvements de translation selon le premier et le second axe (X, Y) dans un plan horizontal parallèle au plan du substrat (1), et un mouvement vertical selon un troisième axe (Z) perpendiculaire au plan du substrat (1), ledit mouvement vertical définissant une distance prédéterminée entre l'orifice (5) du dispositif de dispense de photorésist (4) et le substrat (1), le support (2) du substrat étant dans une position fixe.

4. Méthode selon l'une quelconque des revendications 1 à 3 **caractérisée en ce qu'**elle comprend une étape de mesure de la masse du photorésist pendant le dépôt sur le substrat (1) au moyen d'un dispositif de pesage (3) associé au réservoir de photorésist (7) séparé de l'enceinte (20), ledit dispositif de pesage (3) contrôlant la masse du photorésist (6) acheminé vers l'orifice (5) du dispositif de dispense (4) interrompt le dépôt du photorésist (6) lorsqu'une quantité de photorésist (6) mesurée atteint une masse prédéterminée.

5. Méthode selon la revendication 3 **caractérisée en ce qu'**elle comprend une étape de mesure de la masse du photorésist pendant le dépôt sur le substrat (1) au moyen d'un dispositif de pesage (3) associé support (2) du substrat (1), ledit dispositif de pesage (3) contrôlant la masse du photorésist (6) déposé sur le substrat (1) interrompt le dépôt du photorésist (6) lorsqu'une quantité de photorésist (6) mesurée atteint une masse prédéterminée.

6. Méthode selon l'une quelconque des revendications 1 à 5 **caractérisée en ce qu'**elle comprend une étape de chauffage du support (2) lors du dépôt de la couche de photorésist (6) sur le substrat (1).

7. Méthode selon l'une quelconque des revendications 1 à 5 **caractérisée en ce qu'**elle comprend une étape de chauffage du photorésist par au moins un corps de chauffe intégré au dispositif de dispense (4) ou au réservoir (7).

8. Appareil de dispense d'une couche de photorésist (6) sur un substrat (1) substantiellement plan placé sur un support (2) horizontal, ledit appareil comprenant au moins un dispositif de dispense de photorésist (4), placé au-dessus du substrat (1), relié à un réservoir de photorésist (7), ledit dispositif de dispense (4) comportant un orifice (5) apte à déposer une couche de photorésist sur le substrat (1), l'appareil de dispense est **caractérisé en ce qu'**il comprend :
- une enceinte (20), englobant au moins le dispositif de dispense (4) de photorésist, le support (2) et le substrat (1), couplée à une pompe à vide (21) destinée à créer un vide partiel à l'intérieur de ladite enceinte (20),
- un dispositif d'entraînement configuré de manière à engendrer, sur le support (2) du substrat (1), des mouvements de translation selon un premier axe (X ou Y) et sur le dispositif de dispense de photorésist (4) des mouvements de translation selon un second axe (Y ou X) perpendiculaire au premier axe (X ou Y), le premier axe et le second axe (X, Y) étant parallèles au plan du substrat (1) ou de manière à engendrer sur le support (2) du substrat (1) et/ou sur le dispositif de dispense de photorésist (4) des mouvements de translation selon le premier axe et le second axe (X, Y), de sorte que le photorésist forme une trajectoire prédéterminée sur le substrat (1) et s'étale en une couche homogène d'épaisseur uniforme sur ledit substrat (1).

9. Appareil selon la revendication 8 **caractérisé en ce que** le dispositif d'entraînement est configuré de manière à engendrer sur le support (2) du substrat (1) des mouvements de translation selon le premier et le second axe (X, Y) dans un plan horizontal parallèle au plan du substrat (1) et un mouvement vertical selon un troisième axe (Z) perpendiculaire au plan du substrat (1), ledit mouvement vertical définissant une distance prédéterminée entre l'orifice (5) du dispositif de dispense de photorésist (4) et le substrat (1), le dispositif de dispense de photorésist (4) étant dans une position fixe au dessus du substrat (1).

10. Appareil selon la revendication 8 **caractérisé en ce que** le dispositif d'entraînement est configuré de manière à engendrer sur le dispositif de dispense de photorésist (4) des mouvements de translation selon le premier et le second axe (X, Y) dans un plan horizontal parallèle au plan du substrat (1) et un mouvement vertical selon un troisième axe (Z) perpendiculaire au plan du substrat (1), ledit mouvement vertical définissant une distance prédéterminée entre l'orifice (5) du dispositif de dispense de photorésist (4) et le substrat (1), le support (2) du substrat (1) étant dans une position fixe.

11. Appareil selon l'une quelconque des revendications 8 à 10 **caractérisé en ce qu'**il comprend un dispositif de pesage (3) associé au réservoir de photorésist (7) séparé de l'enceinte (20), ledit dispositif de pesage (3) étant configuré de manière à contrôler la masse du photorésist (6) acheminée vers l'orifice (5) du dispositif de dispense (4) et à interrompre le dépôt du photorésist (6) lorsqu'une quantité de photorésist (6) mesurée atteint une masse prédéterminée.

12. Appareil selon la revendication 10 **caractérisé en ce qu'**il comprend un dispositif de pesage (3) associé au support (2) du substrat (1), ledit dispositif de pesage (3) étant configuré de manière à contrôler la masse du photorésist (6) déposé sur le substrat (1) et à interrompre le dépôt du photorésist (6) lorsqu'une quantité de photorésist (6) mesurée atteint une masse prédéterminée.

13. Appareil selon l'une quelconque des revendications 8 à 12 caractérisée en ce le support (2) du substrat (1) comporte au moins un corps de chauffe.

14. Appareil selon l'une quelconque des revendications 8 à 12 caractérisée en ce le dispositif de dispense de photorésist (4) ou le réservoir (7) de photorésist comporte au moins un corps de chauffe.

## Patentansprüche

1. Verfahren zur Aufbringung einer Fotolackschicht (6) auf einem im wesentlichen ebenen Substrat (1), das auf einem waagrechten Träger (2) platziert ist, wobei die Fotolackschicht (6) auf dem Substrat (1) durch einen Apparat aufgebracht wird, der eine Fotolack-Auftragsvorrichtung (4) umfasst, platziert oberhalb des Substrats (1) und verbunden mit einem Fotolackbehälter (7), wobei das Verfahren **dadurch gekennzeichnet ist, dass** es die folgenden Schritte umfasst:
- vorherige Erzeugung eines teilweisen Vakuums innerhalb einer Einfassung (20), die mindestens die Fotolack-Auftragsvorrichtung (4), den Träger (2) und das Substrat (1) umfasst,
- Aktivieren eine Antriebvorrichtung, die auf dem Träger (2) des Substrats (1) Verschiebungsbewegungen gemäß einer ersten Achse (X oder Y) erzeugt und auf der Fotolack-Auftragsvorrichtung (4) Verschiebungsbewegungen gemäß einer zweiten Achse (Y oder X), die senkrecht zur ersten Achse (X oder Y) ist, wobei die erste Achse und die zweite Achse (X, Y) parallel zur Ebene des Substrats (1) sind, oder die auf dem Träger (2) des Substrats (1) und/oder auf der Fotolackschicht-Aufbringungsvorrichtung (4) Verschiebungsbewegungen gemäß der ersten Achse und der zweite Achse (X, Y) erzeugt, sowie
- Auftragung, mittels der Aufbringungsvorrichtung (4), einer Fotolackschicht (6) auf dem Substrat, wobei die Fotolackschicht (6) durch mindestens eine Öffnung (5) der genannten Aufbringungsvorrichtung (4) nach einem vorgegebenen Weg auf das Substrat (1) läuft und sich in einer homogenen Schicht von gleichmäßiger Dicke auf besagtem Substrat (1) ausbreitet.

2. Verfahren nach Anspruch 1, **dadurch gekennzeichnet, dass** die Antriebvorrichtung auf dem Träger (2) des Substrats Verschiebungsbewegungen gemäß der ersten und der zweiten Achse (X; Y) in einer waagrechten Ebene parallel zur Ebene des Substrats (1) erzeugt sowie gemäß einer dritten Achse (Z) senkrecht zur Ebene des Substrats (1), wobei die vertikale Bewegung einen vorgegebenen Abstand zwischen der Öffnung (5) der Fotolack-Auftragsvorrichtung (4) und dem Substrat (1) definiert, wobei die Fotolack-Auftragsvorrichtung (4) sich in einer festen Position oberhalb des Substrats (1) befindet.

3. Verfahren nach Anspruch 1, **dadurch gekennzeichnet, dass** die Antriebvorri chtung auf der Fotolack-Auftragsvorrichtung (4) Verschiebungsbewegungen gemäß der ersten und der zweiten Achse (X; Y) in einer waagrechten Ebene parallel zur Ebene des Substrats (1) erzeugt sowie eine vertikale Bewegung gemäß einer dritten Achse (Z) senkrecht zur Ebene des Substrats (1), wobei die vertikale Bewegung einen vorgegebenen Abstand zwischen der Öffnung (5) der Fotolack-Auftragsvorrichtung (4) und dem Substrat (1) definiert, wobei der Träger (2) des Substrats sich in einer festen Position befindet.

4. Verfahren nach einem beliebigen der Ansprüche 1 bis 3, **dadurch gekennzeichnet, dass** es ein Messschritt der Masse der Fotolackschicht während des Auftragens auf dem Substrat (1) mittels einer Wiegevorrichtung (3) umfasst, die mit dem Fotolackbehälter (7) verbunden und von der Einfassung (20) getrennt ist, wobei die Wiegevorrichtung (3) die Masse der Fotolackschicht (6) kontrolliert, die der Öffnung (5) der Aufbringungsvorrichtung (4) zugeführt wird, und das Auftragen der Fotolackschicht (6) abbricht, wenn die gemessene Fotolackmenge (6) eine vorgegebene Masse erreicht.

5. Verfahren nach Anspruch 3, **dadurch gekennzeichnet, dass** es ein Messschritt der Masse der Fotolackschicht während des Auftragens auf das Substrat (1) mittels einer Wiegevorrichtung (3) umfasst, die mit dem Träger (2) des Substrats (1) verbunden ist, wobei die Wiegevorrichtung (3) die Masse der Fotolackschicht (6) kontrolliert, die auf das Substrat (1) aufgebracht wird, und das Auftragen der Fotolackschicht (6) abbricht, wenn die gemessene Fotolackmenge (6) eine vorgegebene Masse erreicht.

6. Verfahren nach einem beliebigen der Ansprüche 1 bis 5, **dadurch gekennzeichnet, dass** es ein Erwärmungsschritt des Trägers (2) beim Auftragen der Fotolackschicht (6) auf dem Substrat (1) umfasst.

7. Verfahren nach einem beliebigen der Ansprüche 1 bis 5, **dadurch gekennzeichnet, dass** es ein Erwärmungsschritt der Fotolackschicht durch mindestens einen mit der Aufbringungsvorrichtung (4) oder dem Behälter (7) integrierten Heizkörper umfasst.

8. Apparat zur Aufbringung einer Fotolackschicht (6) auf einem im wesentlichen ebenen Substrat (1), das auf einem waagrechten Träger (2) platziert ist, mit mindestens einer Fotolack-Auftragsvorrichtung (4), platziert oberhalb des Substrats (1) und verbunden mit einem Fotolackbehälter (7), wobei die Aufbringungsvorrichtung (4) eine Öffnung (5) umfasst, die zur Auftragung einer Fotolackschicht auf dem Substrat (1) geeignet ist, wobei der Aufbringungsapparat **dadurch gekennzeichnet ist, dass** er folgendes umfasst:
- eine Einfassung (20), die mindestens die Fotolack-Aufbringungsvorrichtung (4), den Träger (2) und das Substrat (1) umfasst und an eine Vakuumpumpe (21) gekoppelt ist, die ein teilweises Vakuum in der Einfassung (20) erzeugen soll,
- eine Antriebvorrichtung, die auf dem Träger (2) des Substrats (1) Verschiebungsbewegungen gemäß einer ersten Achse (X oder Y) erzeugt und auf der Fotolack-Auftragsvorrichtung (4) Verschiebungsbewegungen gemäß einer zweiten Achse (Y oder X), die senkrecht zur erste Achse (X oder Y) ist, wobei die erste Achse und die zweite Achse (X, Y) parallel zur Ebene des Substrats (1) sind, oder die auf dem Träger (2) des Substrats (1) und/oder auf der Fotolackschicht-Aufbringungsvorrichtung (4) Verschiebungsbewegungen gemäß der ersten Achse und der zweite Achse (X, Y) erzeugt, so dass die Fotolackschicht (6) auf dem Substrat (1) einen vorgegeben Weg bildet und sich in einer homogenen Schicht von gleichmäßiger Dicke auf besagtem Substrat (1) ausbreitet.

9. Apparat nach Anspruch 8, **dadurch gekennzeichnet, dass** die Antriebvorrichtung auf dem Träger (2) des Substrats Verschiebungsbewegungen gemäß der ersten und der zweiten Achse (X, Y) in einer waagrechten Ebene parallel zur Ebene des Substrats (1) erzeugt sowie eine vertikale Bewegung gemäß einer dritten Achse (Z) senkrecht zur Ebene des Substrats (1), wobei die vertikale Bewegung einen vorgegebenen Abstand zwischen der Öffnung (5) der Fotolack-Auftragsvorrichtung (4) und dem Substrat (1) definiert, wobei die Fotolack-Auftragsvorrichtung (4) sich in einer festen Position oberhalb des Substrats (1) befindet.

10. Apparat nach Anspruch 8, **dadurch gekennzeichnet, dass** die Antriebvorrichtung auf der Fotolack-Auftragsvorrichtung (4) Verschiebungsbewegungen gemäß der ersten und der zweiten Achse (X, Y) in einer waagrechten Ebene parallel zur Ebene des Substrats (1) erzeugt sowie eine vertikale Bewegung gemäß einer dritten Achse (Z) senkrecht zur Ebene des Substrats (1), wobei die vertikale Bewegung einen vorgegebenen Abstand zwischen der Öffnung (5) der Fotolack-Auftragsvorrichtung (4) und dem Substrat (1) definiert, wobei der Träger (2) des Substrats (1) sich in einer festen Position befindet.

11. Apparat nach einem beliebigen der Ansprüche 8 bis 10, **dadurch gekennzeichnet, dass** er eine Wiegevorrichtung (3) umfasst, die mit dem Fotolackbehälter (7) verbunden und von der Einfassung (20) getrennt ist, wobei die Wiegevorrichtung (3) die Masse der Fotolackschicht (6) kontrolliert, die der Öffnung (5) der Aufbringungsvorrichtung (4) zugeführt wird, und das Auftragen der Fotolackschicht (6) abbricht, wenn die gemessene Fotolackmenge (6) eine vorgegebene Masse erreicht.

12. Apparat nach Anspruch 10, **gekennzeichnet dadurch, dass** er eine Wiegevorrichtung (3) umfasst, die mit dem Träger (2) des Substrats verbunden (1) ist, wobei die Wiegevorrichtung (3) die Masse der Fotolackschicht (6) kontrolliert, die auf das Substrat aufgebracht (1) wird, und das Auftragen der Fotolackschicht (6) abbricht, wenn die gemessene Fotolackmenge (6) eine vorgegebene Masse erreicht.

13. Apparat nach einem beliebigen der Ansprüche 8 bis 12, **dadurch gekennzeichnet, dass** der Träger (2) des Substrats (1) mindestens einen Heizkörper umfasst.

14. Apparat nach einem beliebigen der Ansprüche 8 bis 12, **dadurch gekennzeichnet, dass** die Fotolack-Auftragsvorrichtung (4) oder der Fotolackbehälter (7) mindestens einen Heizkörper umfasst.

## Claims

1. Method for dispensing a photoresist layer (6) on a substantially plane substrate (1) placed on a horizontal support (2), the photoresist (6) being deposited on the substrate (1) by an apparatus comprising a photoresist dispensing device (4) placed above the substrate (1), connected to a photoresist tank (7), the method being **characterized in that** it comprises the following steps:
- first creating a partial vacuum inside an enclosure (20) encompassing at least the photoresist dispensing device (4), the support (2) and the substrate (1),
- activating a driving device generating, on the support (2) of the substrate (1), translation movements along a first axis (X or Y) and on the photoresist dispensing device (4), translation movements along a second axis (Y or X) perpendicular to the first axis (X or Y), the first axis and the second axis (X, Y) being parallel to the plane of the substrate (1) or generating on the support (2) of the substrate (1) and/or on the photoresist dispensing device (4) translation movements along the first axis and the second axis (X, Y), and
- depositing by means of the dispensing device (4) a photoresist layer (6) on the substrate, the photoresist (6) flowing through at least one opening (5) of said dispensing device (4) along a predetermined path on the substrate (1) spreads into a homogeneous layer having a uniform thickness on said substrate (1).

2. Method according to claim 1 **characterized in that** the driving device generates translation movements on the support (2) of the substrate along the first and the second axis (X, Y) in a horizontal plane parallel to the plane of the substrate (1) and along a third axis (Z) perpendicular to the plane of the substrate (1), said vertical movement defining a predetermined distance between the opening (5) of the photoresist dispensing device (4) and the substrate (1), the photoresist dispensing device (4) being in a fixed position above the substrate (1).

3. Method according to claim 1 **characterized in that** the driving device generates translation movements on the photoresist dispensing device (4) along the first and the second axis (X, Y) in a horizontal plane parallel to the plane of the substrate (1), and a vertical movement along a third axis (Z) perpendicular to the plane of the substrate (1), said vertical movement defining a predetermined distance between the opening (5) of the photoresist dispensing device (4) and the substrate (1), the support (2) of the substrate being in a fixed position.

4. Method according to anyone of claims 1 to 3 **characterized in that** it comprises a step of measuring the photoresist mass during the deposition on the substrate (1) by means of a weighing device (3) associated with the photoresist tank (7) separated from the enclosure (20), said weighing device (3) controlling the photoresist mass (6) directed towards the opening (5) of the dispensing device (4) interrupts the deposition of the photoresist (6) when a measured quantity of photoresist (6) reaches a predetermined mass.

5. Method according to claim 3 **characterized in that** it comprises a step of measuring the photoresist mass during the deposition on the substrate (1) by means of a weighing device (3) associated with the support (2) of the substrate (1), said weighing device (3) controlling the photoresist mass (6) deposited on the substrate (1) interrupts the deposition of the photoresist (6) when a measured quantity of photoresist (6) reaches a predetermined mass.

6. Method according to anyone of claims 1 to 5 **characterized in that** it comprises a step of heating the support (2) during the deposition of the photoresist layer (6) on the substrate (1).

7. Method according to anyone of claims 1 to 5 **characterized in that** it comprises a step of heating the photoresist by at least one heating body integrated in the dispensing device (4) or in the tank (7).

8. Apparatus for dispensing a photoresist layer (6) on a substantially plane substrate (1) placed on a horizontal support (2), said apparatus comprising at least one photoresist dispensing device (4), placed above the substrate (1), connected to a photoresist tank (7), said dispensing device (4) including an opening (5) suitable for depositing a photoresist layer on the substrate (1), the dispensing apparatus being **characterized in that** it comprises:
- an enclosure (20), encompassing at least the photoresist dispensing device (4), the support (2) and the substrate (1), coupled to a vacuum pump (21) intended to create a partial vacuum inside said enclosure (20),
- a driving device configured to generate, on the support (2) of the substrate (1), translation movements along a first axis (X or Y) and on the photoresist dispensing device (4) translation movements along a second axis (Y or X) perpendicular to the first axis (X or Y), the first axis and the second axis (X, Y) being parallel to the plane of the substrate (1) or to generate on the support (2) of the substrate (1) and/or on the photoresist dispensing device (4) translation movements along the first axis and the second axis (X, Y), so that the photoresist forms a predetermined path on the substrate (1) and spreads into a homogeneous layer having a uniform thickness on said substrate (1).

9. Apparatus according to claim 8 **characterized in that** the driving device is configured to generate translation movements on the support (2) of the substrate (1) along the first and the second axis (X, Y) in a horizontal plane parallel to the plane of the substrate (1) and a vertical movement along a third axis (Z) perpendicular to the plane of the substrate (1), said vertical movement defining a predetermined distance between the opening (5) of the photoresist dispensing device (4) and the substrate (1), the photoresist dispensing device (4) being in a fixed position above the substrate (1).

10. Apparatus according to claim 8 **characterized in that** the driving device is configured to generate translation movements on the photoresist dispensing device (4) along the first and the second axis (X, Y) in a horizontal plane parallel to the plane of the substrate (1) and a vertical movement along a third axis (Z) perpendicular to the plane of the substrate (1), said vertical movement defining a predetermined distance between the opening (5) of the photoresist dispensing device (4) and the substrate (1), the support (2) of the substrate (1) being in a fixed position.

11. Apparatus according to anyone of claims 8 to 10 **characterized in that** it comprises a weighing device (3) associated with the photoresist tank (7) separated from the enclosure (20), said weighing device (3) being configured to control the photoresist mass (6) directed towards the opening (5) of the dispensing device (4) and to interrupt the deposition of the photoresist (6) when a measured quantity of photoresist (6) reaches a predetermined mass.

12. Apparatus according to claim 10 **characterized in that** it comprises a weighing device (3) associated with the support (2) of the substrate (1), said weighing device (3) being configured to control the photoresist mass (6) deposited on the substrate (1) and to interrupt the deposition of the photoresist (6) when a measured quantity of photoresist (6) reaches a predetermined mass.

13. Apparatus according to anyone of claims 8 to 12 **characterized in that** the support (2) of the substrate (1) comprises at least one heating body.

14. Apparatus according to anyone of claims 8 to 12 **characterized in that** the photoresist dispensing device (4) or the photoresist tank (7) comprises at least one heating body.
